Europäisches Patentamt

European Patent Office

Office européen des brevets

(11) Publication number: **0 272 744**
**A2**

## (12) EUROPEAN PATENT APPLICATION

(21) Application number: 87202500.2

(22) Date of filing: 14.12.87

(51) Int. Cl.4: **H03K 17/04** , H03K 4/64

(30) Priority: 19.12.86 GB 8630409

(43) Date of publication of application:
29.06.88 Bulletin 88/26

(84) Designated Contracting States:
DE FR GB IT SE

(71) Applicant: PHILIPS ELECTRONIC AND
ASSOCIATED INDUSTRIES LIMITED
Arundel Great Court 8 Arundel Street
London WC2R 3DT(GB)

(84) GB

(71) Applicant: N.V. Philips' Gloeilampenfabrieken
Groenewoudseweg 1
NL-5621 BA Eindhoven(NL)

(84) DE FR IT SE

(72) Inventor: Gent, Derek James
C/O MULLARD LIMITED New Road
Mitcham Surrey CR4 4XY(GB)

(74) Representative: Cole, Bernard Victor et al
PHILIPS ELECTRONICS Patents and Trade
Marks Department Centre Point New Oxford
Street
London WC1A 1QJ(GB)

(54) Circuit arrangement with a high voltage bipolar transistor.

(57) A high voltage bipolar transistor (TR1) is provided in a line deflection circuit comprising a diode (D), a retrace capacitor (CR), a trace capacitor (CT) and a deflection coil (Ly) connected as shown. The transistor (TR1) is controlled from a line oscillator (LO) whose pulse waveform is applied by way of a driver stage (DR) and a stage (AC) controlling the amplitude of the forward current for the base of the transistor (TR1). A signal representing the amplitude of the relative power in the transistor (TR1) is derived from a power sensor (PS) and applied to a power minimum detector (PM) whose output controls the amplitude control stage (AC) to set the transistor (TR1) for minimum power dissipation.

Fig.1.

# CIRCUIT ARRANGEMENT WITH A HIGH VOLTAGE BIPOLAR TRANSISTOR

This invention relates to a circuit arrangement comprising a high voltage bipolar power transistor stage, drive means for supplying a pulsatory switching signal between the base and emitter of said transistor for periodically causing said transistor to saturate, a load impedance connected to the collector of said transistor, means for supplying the collector current for the saturated transistor from a voltage source which collector current is interrupted in response to said pulsatory switching signal, the connection for supplying the pulsatory switching signal between the base and emitter of said transistor including an impedance device.

Such circuits are disclosed in UK patent specification No. 1 234 607 and are used in particular with cathode ray tube displays for television or data graphics as line output stages. Data graphic displays often employ a line frequency which is higher than that used in broadcast television receivers resulting in a shorter flyback period. Line output stages for such data graphic displays require a greater degree of control of their operation than such stages for broadcast television receivers and to this end it is an object of the invention to provide a circuit arrangement suitable for use in such higher line frequency data graphic displays.

The invention provides a circuit arrangement comprising a high voltage bipolar power transistor stage, drive means for supplying a pulsatory switching signal between the base and emitter of said transistor for periodically causing said transistor to saturate, a load impedance connected to the collector of said transistor, means for supplying the collector current for the saturated transistor from a voltage source which collector current is interrupted in response to said pulsatory switching signal, the connection for supplying the pulsatory switching signal between the base and emitter of said transistor including an impedance device, characterised in that said impedance device is a controllable variable impedance which is controlled in response to the relative power in the transistor stage to control the amplitude of the drive current supplied to the base of the transistor when it is saturated substantially at the optimum level for the minimum power dissipation in said transistor.

The above arrangement has the advantage that by controlling the amplitude of the drive current for the transistor the storage time for the charge carriers in that transistor are optimised to prevent over saturation and hence excessive power dissipation.

The variable impedance may be controlled so as to control the period between the end of the pulsatory switching signal and the interruption of the collector current for achieving optimum drive.

The transistor stage may comprise sensing means for producing a signal which corresponds to the relative amplitude of the power in the transistor stage, detector means for receiving the relative power signal and determining this power is at or near to a minimum, the detector means having an output for controlling said impedance device in response to the relative power signal. Conveniently the sensing means may comprise a resistor connected to the emitter of the transistor which resistor conveys the average current flowing through the transistor, the voltage across the resistor forming the signal being applied to the detector means for sensing when the voltage is at or near a minimum.

The controllable variable impedance may comprise a capacitor and a parallel resistive path, the resistive path comprising a transistor whose conductivity is controlled in response to relative power.

The above and other features of the invention will now be described, by way of example, with reference to the accompanying drawings, in which:-

Figure 1 is a diagram, partly in block form, of one embodiment of a circuit arrangement according to the invention,

Figure 2 shows various waveforms associated with the operation of the arrangement of Figure 1, and

Figure 3 is a diagram partly in block form, of a further embodiment of a circuit arrangement according to the invention.

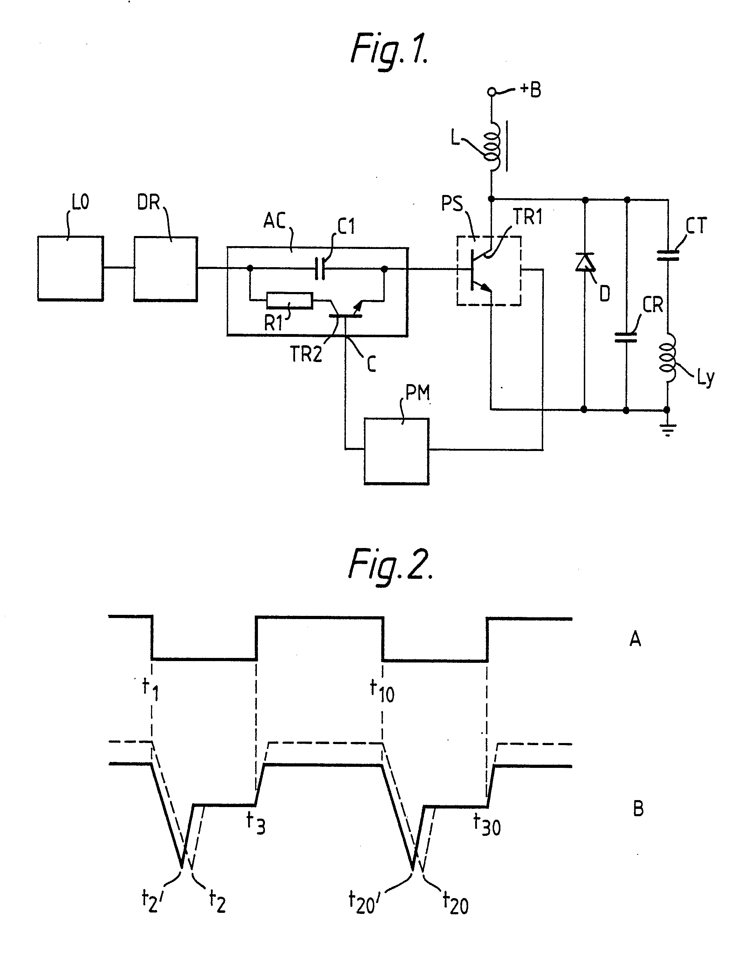

Figure 1 is a diagram, partly in block - schematic form, of a line deflection circuit having a line output stage for energising a line deflection coil Ly. The line output stage comprises a high voltage npn bipolar power switching transistor TR1 whose collector is connected to a voltage supply B + through an inductor L whilst its emitter is connected to earth. The inductor L may be the primary of a transformer the secondary windings of which supply respectively the eht supply for the final anode of a display tube associated with the deflection circuit and the low voltage supply or supplies for other parts of the circuit. A diode D and a retrace capacitor CR are each connected in parallel with the transistor TR1 although the diode may be omitted if the transistor TR1 is capable of conducting in the reverse direction. A trace capacitor CT and the deflection coil Ly are serially connected between the collector of transistor TR1 and earth.

The line output stage operates in known manner with the voltage stored in trace capacitor CT producing the required sawtooth current through deflection coil Ly which initially flows through the diode D for a first part of a trace period and subsequently through transistor TR1 through a second part of the trace period. The retrace period is initiated at the instant transistor TR1 becomes non-conducting, which transistor has been previously rendered conducting prior to or at the commencement of the second part of the trace period by positive going drive pulses applied to its base. During the retrace period the inductance and capacitance in the line output stage resonate to produce a half sine wave flyback pulse which is followed by the start of a further trace period. The time at which the flyback pulse commences depends on the charge storage time of transistor TR1 as will be described below.

A line frequency signal source such as a line oscillator stage LO produces pulses at line frequency which pulses are applied from its output to the input of a driver stage DR. The drive pulse output of driver stage DR is applied to the input of an amplitude control device AC in which the amplitude of the forward drive base current can be varied depending upon a signal applied to its control input C, the resulting drive pulse from the device AC being applied to the base of transistor TR1. With such a transistor it is preferable to have the transistor operating under optimum conditions such that the power in the transistor is at a minimum. With the present arrangement this is achieved by the inclusion of a power sensor PS for determining the relative power in the transistor TR1. This power sensor PS is shown as a broken line box surrounding the transistor and may in one form comprise a device in thermal contact with the transistor to measure its temperature which will increase with an increase of power in the transistor. The output of the power sensor PS is applied to the input of a power minimum detector PM which looks for the minimum power in transistor TR1. The output of the power minimum detector PM is applied to the control input C of the amplitude control AC to change the amplitude of the forward drive base current when the current and hence power through transistor TR1 is above the minimum so as to optimise the storage time of this transistor. The manner in which this is achieved will be described with reference to Figure 2.

Figure 2 shows idealised waveforms associated with the line deflection circuit of Figure 1 with Figure 2A showing the output of the line oscillator LO for application to the driver stage DR. The initial base current for transistor TR1 is shown in broken line in Figure 2B which starts to reduce in magnitude at times $t_1$, $t_{10}$ on receipt of the negative going edge in the drive pulse shown in Figure 2A. The charge carriers in transistor TR1 are then removed with the base current reversing in polarity until times $t_2$, $t_{20}$ when the transistor comes out of saturation and the transistor is very rapidly cut-off to initiate the flyback period. At times $t_3$, $t_{30}$ during the following scan period transistor TR1 becomes forward biased when a positive drive pulse is applied to the base of this transistor and derived from the line oscillator pulse in Figure 2A. This cycle is then repeated.

The drive current applied to the base of the line output transistor TR1 has an effect on the quantity of charge carriers in the transistor and when the drive current is in excess of that required to cause the transistor to just saturate the transistor contains an excess of charge carriers and the storage time required to remove these charge carriers at transistor cut-off is increased. In the case of high voltage bipolar switching transistors it is normal for the drive current to be greater than that required for a nominal transistor to be just saturated in order to cater for the spread in characteristics found with transistors of the same type and it will be appreciated that due to the spreads in these characteristics the storage times for various transistors when driven with the same drive current may differ. If the transistor TR1 is either under or over saturated it will not be operating at its optimum drive requirement and therefore at minimum power consumption. In the broken line waveform of Figure 2B it is assumed that the drive current is greater than that required for transistor TR1 to just saturate. With the arrangement of Figure 1 the output from the minimum power detector PM is arranged to control the amplitude control device AC such that the forward drive current applied to the base of transistor TR1 during each scan period is reduced to reduce the quantity of charge carriers in the transistor and so reduce the storage time until it is at or substantially at the optimum level, this being shown by the full line waveform in Figure 2B.

In the arrangement of Figure 1 the amplitude control device AC comprises a capacitor C1 connected in parallel with the series arrangement of a resistor R1 and a npn transistor TR2 which together with the leakage inductance of a driver transformer (not shown) in the driver stage DR are selected to provide the drive for transistor TR1, the base of transistor TR2 forming the control input C for this device. The output of the power minimum detector controls the degree of conduction of transistor TR2 and hence its resistance to vary the amplitude of the drive current at the base of transistor TR1 and hence its charge carrier storage time.

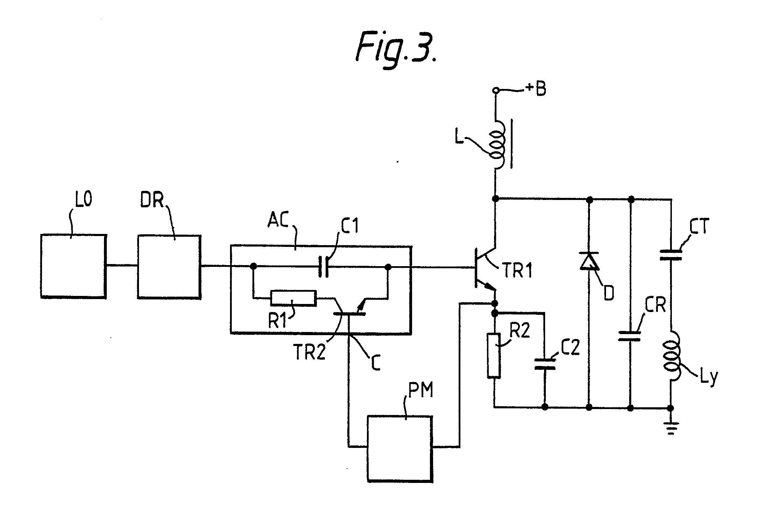

In the description of Figure 1 the power sensor PS is described as being a temperature sensor. However, the sensor PS could instead sense various voltages and/or currents at electrodes of transistor TR1 to allow the minimum power to be determined. Alternatively, the total supply current to transistor TR1 stage may be sensed to provide an indication of minimum power. Such an arrangement is shown in Figure 3 which corresponds in general with Figure 1 and where like reference symbols indicate like components. In Figure 3 the power sensor PS is replaced by a resistor R2 of small value (a few ohms) provided between the emitter of transistor TR1 and earth; this resistor being shunted by a capacitor C2 whose value is sufficiently high so that it conveys the components at line frequency. The voltage across resistor R2 is directly proportional to the average current through transistor TR1 which voltage is applied to the power minimum detector PM which takes the form of a voltage minimum detector.

## Claims

1. A circuit arrangement comprising a high voltage bipolar power transistor stage, drive means for supplying a pulsatory switching signal between the base and emitter of said transistor for periodically causing said transistor to saturate, a load impedance connected to the collector of said transistor, means for supplying the collector current for the saturated transistor from a voltage source which collector current is interrupted in response to said pulsatory switching signal, the connection for supplying the pulsatory switching signal between the base and emitter of said transistor including a impedance device, characterised in that said impedance device is a controllable variable impedance which is controlled in response to the relative power in the transistor stage to control the amplitude of the drive current supplied to the base of the transistor when it is saturated substantially at the optimum level for minimum power dissipation in said transistor.

2. An arrangement as claimed in Claim 1, characterised in that said variable impedance is controlled so as to control the period between the end of the pulsatory switching signal and the interruption of said collector current.

3. An arrangement as claimed in Claim 1 or 2, characterised in that said transistor stage comprises sensing means for producing a signal which corresponds to the relative amplitude of the power in the transistor stage, detector means for receiving said relative power signal and determining when said power is at or near to a minimum, said detector means having an output for controlling said impedance device in response to said relative power signal.

4. An arrangement as claimed in Claim 3, characterised in that said sensing means comprises a resistor connected to the emitter of said transistor which resistor conveys the average current flowing through said transistor, the voltage across said resistor forming the signal being applied to said detector means for sensing when said voltage is at or near a minimum.

5. An arrangement as claimed in any one of the preceding claims, characterised in that said controllable variable impedance comprises a capacitor and a parallel resistive path, the resistive path comprising a transistor whose conductivity is controlled in response to said relative power.

## Fig.1.

## Fig.2.

*Fig.3.*